# EUROPEAN PATENT SPECIFICATION

(11) **EP 0 361 404 B1**
(45) Date of publication and mention of the grant of the patent: **13.12.1995**
(21) Application number: 89117779.2
(22) Date of filing: 26.09.1989
(51) Int. Cl.: G06F 11/20

(54) **Memory circuit provided with improved redundant structure**
Speicherschaltung mit verbesserter Redundanzstruktur
Circuit de mémoire muni d'une structure de redondance améliorée

(30) Priority: 27.09.1988 JP 241906/88
(43) Date of publication of application: 04.04.1990
(73) Proprietor: NEC CORPORATION, Tokyo (JP)
(72) Inventor: Ohuchi, Kugao, Tokyo (JP)
(74) Representative: Glawe, Delfs, Moll & Partner

(56) References cited:
- EP-A- 0 034 070
- EP-A- 0 116 440
- EP-A- 0 116 464

## Description

### BACKGROUND OF THE INVENTION

### Field of the Invention:

The present invention relates to a memory circuit, and more particularly to a memory circuit having a redundant structure.

### Description of the Related Art:

The memory capacity of semiconductor memories has been increased remarkably. However, the increase in the memory capacity has resulted in low manufacturing yields due to the low probability of all circuit elements on such a dense structure being fabricated without defect. Thus, it was difficult to obtain a memory in which all the constituent elements are goods.

To solve the above problem, memories having redundant structures have been developed and widely utilized. In a memory having a redundant structure, a redundant array of memory cells is provided in addition to a normal array of memory cells. If a cell or cells in the normal array are faulty or defective, such defective cells are replaced by good cells in the redundant array, so that a functionally good memory can be obtained even though defects may be present in the normal array. Information as to the address of the cells to be replaced is stored by a program circuit which includes a plurality of read only memory cells. When the defective cell in the normal array is to be addressed from the outside, the program circuit operates to inhibit accessing of the defective cell and to cause accessing of a redundant cell in the redundant array. Therefore, as viewed from outside the memory, it appears as if all cells in a normal array are accessible and free of defects. One practical example of this technique is disclosed in the United State Patent No. 4,571,707 issued to Watanabe.

However, in the conventional memory, it is necessary to compare address input to the memory with the address to be replaced by a redundant cell at first by the program circuit. Then, either a normal memory cell or a redundant memory cell is accessed in accordance with the result of the above address comparison. Therefore, access time of the memory is inevitably lowered at least by the time required for the address comparison.

Moreover, in a memory having two or more input/output ports, if one of input/output circuits associated to the input/output ports is defective, it is impossible to save the memory having such defective input/output circuit because replacement of defective elements is limited only to memory cells.

EP-A-34070 discloses a memory circuit according to the precharacterizing part of claim 1. This document discloses a memory subdivided into memory blocks, a circuit having peripheral circuit blocks for each of the memory blocks, whereby each of said peripheral circuit blocks provides a read signal from the associated memory block at its output end, the number of output terminals is smaller than the number of memory blocks. A programmable switch circuit connects output terminals to corresponding output ends of peripheral circuits, and the remaining peripheral circuits are isolated from the output terminals.

In this document the redundant memory block can be connected to each I/O-terminal so as to replace defect memory block. Therefore, it is necessary to provide at least one additional output line connecting the redundant memory block with the output of each memory block. This additional output line complicates the structure of whole memory circuit.

### SUMMARY OF THE INVENTION

It is an object of the present invention to provide a memory circuit having an improved redundant structure which can operate at a high speed, and which overcomes the above shortcoming.

This object is achieved by a memory circuit according to claim 1. The dependent claims are related to further advantageous embodiments.

It is an advantage of the present invention to provide a memory circuit having a plurality of repairable input/output circuits.

According to the present invention, the programmable switch circuit isolates the memory block or blocks which are defective or associated with the defective peripheral circuit blocks from the output terminals by the programmable switch circuit while the second number of good memory blocks with the good peripheral circuit blocks are coupled to the second number of output terminals to constitute a functionally good memory circuit. Therefore, it is not necessary to check address information for replacement of memory cells. Thus, the memory circuit according to the invention can operate at a high speed. Moreover, the defective peripheral circuit block is isolated from the output terminal. Thus, the memory having a defective peripheral circuit block can be saved.

### BRIEF DESCRIPTION OF THE DRAWINGS

The above and further objects, features and advantages of the present invention will become more apparent from the following detailed description taken in conjunction with the accompanying drawings, wherein:
Fig. 1 is a schematic block diagram showing a memory circuit in the prior art;
Fig. 2 is schematic block diagram showing a memory circuit according to a first embodiment of the present invention;
Fig. 3 is a schematic circuit diagram showing one example of a program circuit;
Fig. 4 is a schematic circuit diagram showing one example of a switch circuit; and
Fig. 5 is a schematic block diagram of a memory circuit according to a second embodiment of the present invention:

### DETAILED DESCRIPTION OF THE INVENTION

### Prior Art:

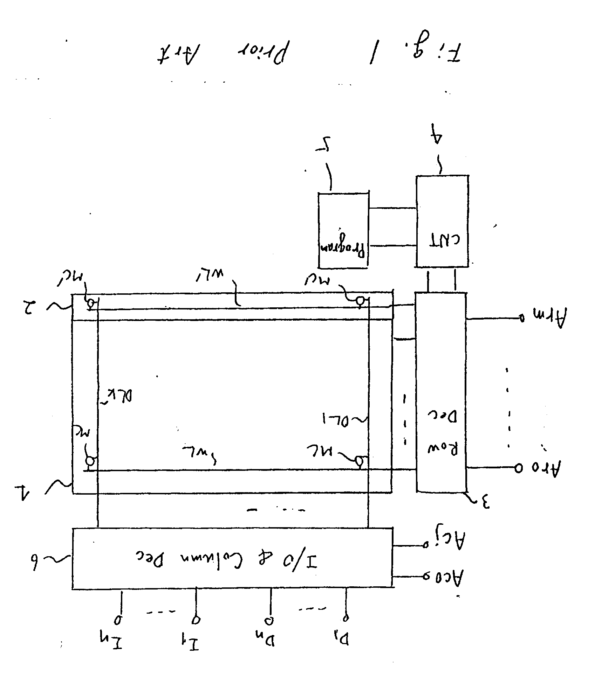

With reference to Fig. 1, a memory circuit in the prior art will be explained.

As shown in Fig. 1, the memory circuit comprises a normal memory array 1 having word lines WL, bit lines DLₗ - DLₖ and memory cells MC arranged in a known matrix form, and a redundant memory array 2 having a redundant word line WL′ and redundant memory cells MC′ connected to the redundant word line WL′ and the bit lines DLₗ - DLₙ. A row decoder 3 is coupled to the word lines WL and the redundant word line WL′ and operatively selects one of the word lines WL and WL′. A program circuit 5 stores address information of a defective row, i.e. word of the normal array 1 and a control circuit 4 compares input row address information represented by row address signals Aro - Arm applied to the row decoder 3 with the address information stored in the program circuit 5 and controls the row decoder 3 in such manner that the row decoder 3 selects one of the word lines WL when the input row address information is not coincident with the address information stored in the program circuit 5 and selects the redundant word line WL′ when the input address information coincides with the stored address information. An I/O and column decoder block 6 selects "n" (N < k) of bit lines for data output through output terminals Dₗ - Dₙ in a read mode and for writing thereto data applied to input terminals Iₗ - Iₙ in a write mode in accordance with column address signals Aco - Acj. In the above memory circuit, before selecting one of the word lines it is necessary to compare the input address information with the address information stored in the program circuit. In other words, it is necessary to wait for completion of the above comparison of the address information before word line selection. Therefore, a certain delay time corresponding to the comparison operation is inevitably introduced in access time of the memory circuit, resulting in a low speed access operation.

Moreover, when a part of the block 6 is defective and a certain bit of input or output is dead, the memory cannot be utilized even when all the normal memory cells MC are good.

### Embodiments:

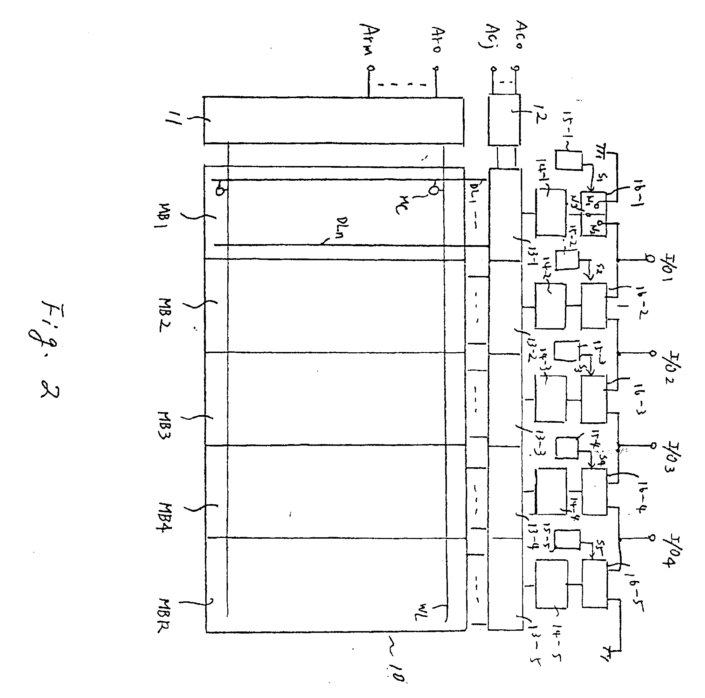

With reference to Fig. 2, a memory circuit according to a first embodiment of the present invention will be explained.

A memory cell array 10 includes a plurality of memory blocks MB1 - MB4 and a redundant memory block MBR. A plurality of word lines WL connected to a row decoder 11 are extending through the memory array 10 in a row direction. Each of the memory blocks MB1 - MB4 and MBR includes the same number (n) of bit lines DLₗ - DLₙ. A plurality of memory cells MC are arranged in a known way in the array 10. The memory blocks MB1 - MB4 and MBR are provided with column selection circuits 13-1 to 13-5 and input/output buffer circuits 14-1 to 14-5, respectively. Each of the column selector circuits 13-1 to 13-5 selectively forms a signal path between one of the bit lines DLₗ - DLₙ of the corresponding one of the memory blocks and the corresponding one of the input/output buffers based on outputs of a column decoders 12 receiving column address signals Aco - Acj. A plurality of switch circuits 16-1 to 16-5 and a plurality of program circuits 15-1 to 15-5 for setting state of the switch circuits 16-1 to 16-5 respectively are provided for the input/output buffers 14-1 to 14-5, respectively. Each of external input/output terminals I/O₁ to I/O₄ are connected to adjacent two of the switch circuits 16-1 to 16-5 as illustrated. Each of the switch circuits 16-1 to 16-5 has a common node N₃ and two switch nodes N₁ and N₂ to be switched to the common node N₃ under control of a control signal (S₁ - S₅) from the program circuit.

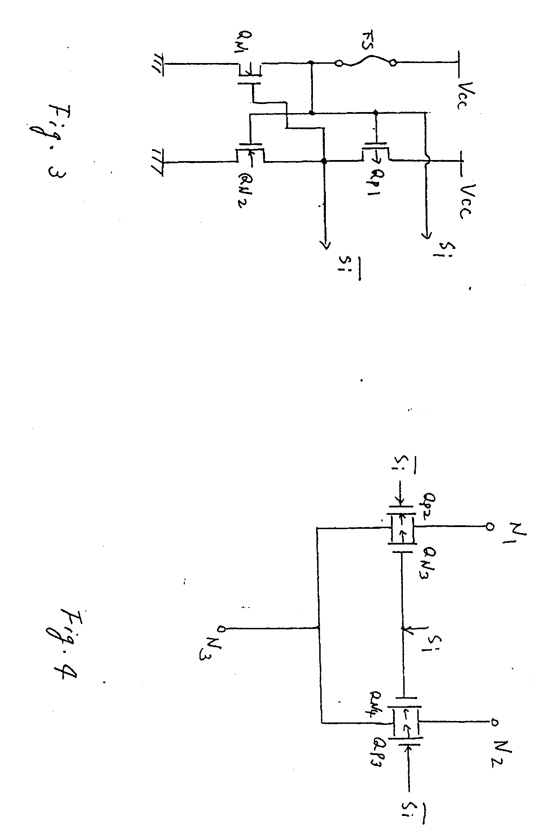

A circuit example of the program circuits 15-1 to 15-5 is shown in Fig. 3. The program circuit includes a fusible link FS such as a polysilicon fuse, a P-channel MOS transistor Q_{P1} and N-channel transistors Q_{N1} and Q_{N2}. In this circuit, a resistance of the fusible link FS is set lower than a on-resistance of the P-channel transistor Q_{P1}. Thus, control signals Si and S̅i̅ (1 ≦ i ≦ 5) are made high and low in levels when the fusible link FS remains uncut and low and high in levels when the fusible link FS is cut, respectively.

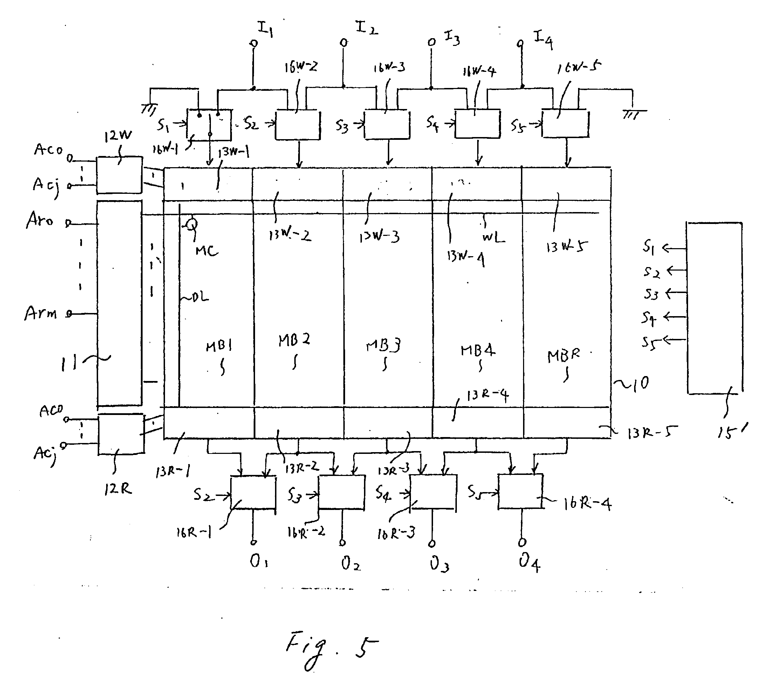

An example of the switch circuits 16-1 to 16-5 is shown in Fig. 4. As illustrated in Fig. 4, a first CMOS transfer gate composed of a P-channel MOS transistor Q_{P2} and an N-channel transistor Q_{N3} connected between the switch node N₁ and the common node N₃ and a second CMOS transfer gate composed of a P-channel MOS transistor Q_{P3} and an N-channel MOS transistor Q_{N4} connected between the switch node N₂ and the common node N₃. When the control signals Si and S̅i̅ are at a high level and a low level, respectively in a first state, the second transfer gate (Q_{P3}, Q_{N4}) is rendered conductive to connect the switch node N₂ to the common node N₃. To the contrary, when the control signals Si and S̅i̅ are at the low level and the high level, respectively in a second state, the first transfer gate (Q_{P2}, Q_{N3}) is rendered conductive to connect the switch node N₁ to the common node N₃.

Operations of the memory of Fig. 1 will be explained below.

In the case where the memory block MB1 includes at least one defective memory cell or the selection circuit 13-1 and/or the input/output buffer 14-1 is defective, the program circuits 15-1 to 15-5 are set in the second state so that the terminals I/O₁ to I/O₄ are connected to the input/output buffers 14-2 to 14-5 through the switch circuits 16-2 to 16-5, respectively. Thus, the defective memory block MB1 or its defective peripheral circuit (13-1, 14-1) is isolated from the terminal I/O₁ while other memory blocks MB2, MB3, MB4 and MBR and their peripheral circuits (13-2 ∼ 13-5, 14-2 ∼ 14-5) are coupled to the terminals I/O₁ to I/O₄ through the switch circuits 16-2 to 16-5, respectively. In this case the input/output buffer 14-1 is connected to an inactive e.g. ground potential through the switch circuit 16-1. This is advantageous for preventing occurrence of noise from the circuits 14-1 and 13-1.

Also, in the case where the memory block MB3 and/or its peripheral circuits 14-3 and 14-3 are defective, the terminals I/O₁, I/O₂, I/O₃ and I/O₄ are coupled to the input/output buffers 14-1, 14-2, 14-4 and 14-5 through the switch circuits 16-1, 16-2, 16-4 and 16-5, respectively. Thus, the defective memory block MB3 and its peripheral circuits 13-3 and 14-3 are isolated from any of the terminals I/O₁ - I/O₄.

According to the present invention, a defective memory block or a defective peripheral circuit is simply isolated from an input/output terminal, and other memory blocks are directly accessed through I/O terminals without any comparison operation of address information.

Therefore, high speed access operation can be attained. Moreover, according to the present invention, the memory circuit with a defective input/output unit can be saved as well as the memory circuit with a defective memory block.

With reference to Fig. 5, a memory circuit according to a second embodiment will be explained.

In place of input/output terminals I/O₁ - I/O₄, input terminals I₁ - I₄ and output terminals O₁ - O₄ are employed in this embodiment. Therefore, selective write circuits 13W-1 to 13W-5 and write switch circuits 16W-1 to 16W-5 are provided for the memory blocks MB1 - MB4 and MBR, respectively and selective read circuits 13R-1 13R-5 and read switch circuits 16R-1 to 16R-4 are provided similarly. The structures of the write switch circuits and the read switch circuit are similar to the switch circuits 16-1 to 16-5 of Fig. 2. A program circuit 15′ generates control signals S₁ to S₅ for controlling the switch circuits. Also, a write column decoder 12W and a read column decoder 12R are provided for controlling the selective write circuits 13W-1 to 13W-5 and the selective read circuits 13R-1 to 13R-5, respectively.

In this memory, if the memory block MB1, the selective write circuit 13W-1 or the selective read circuit 13R-1 is defective, the control signals are set in such manner that the write switch circuits 16W-2 to 16W-5 connect the input terminals I₁ to I₄ to the selective write circuits 13W-2 to 13W-5, respectively and the read switch circuits 16R-1 to 16R-4 connect the selective read circuits 13R-2 to 13R-5 to the output terminals O₁ to O₄, respectively. Thus, the memory blocks MB2 - MB4 and MBR are accessed in parallel through the input terminals I₁ to I₄ and the output terminals O₁ to O₄, respectively.

## Claims

1. A memory circuit comprising
a first number of memory blocks (MB1 - MB4), each having a plurality of memory cells (MC);
a plurality of peripheral circuit blocks (13, 14) each provided for an associated one of said memory blocks (MB1 - MB4), each of said peripheral circuit blocks (13, 14) deriving a read signal at its output end from the associated memory block;
a second number of output terminals (I/O₁ to I/O₂), said second number being smaller than said first number; and
a programmable switch circuit (15, 16) for selectively causing signal path between said second number of output terminals (I/O₁ to I/O₂) and the output ends of said second number of peripheral circuit blocks (13, 14), whereby the remaining peripheral circuit blocks (13, 14) or blocks other than said number of peripheral circuit blocks (13, 14) are fixedly isolated from any of said output terminals (I/O₁ to I/O₂),
**characterized** in that
said programmable switch circuit (15, 16) includes a plurality of switch units (16-1 to 16-5) of said first number,
each of said switch units having a common node (N₃) and a plurality of switch nodes (N₁, N₂) to be selectively connected to the common node (N₃),
the common node (N₃) of each of said switch units (16-1 to 16-5) being connected to the output end of said associated peripheral circuit block (13, 14),
each of said output terminals (I/O₁ to I/O₂) being electrically coupled to the switch nodes (N₁, N₂) of the different two or more switch units (16-1 to 16-5).

2. A memory circuit according to claim 1, in which said memory blocks (MB1-MB4) have a plurality of word lines (WL) in common.

3. A memory circuit according to claim 1, in which each of said peripheral circuit blocks (13,14) includes a column selection circuit (13) for selecting one of the columns of the associated memory block and a buffer circuit (14) for amplifying a signal from the selected column.

4. A memory circuit according to any preceeding claim, comprising a plurality of programmable control means (15-1 to 15-5) for controlling conductive states of said switch units (16-1 to 16-5).

## Patentansprüche

1. Speicherschaltung mit
einer ersten Zahl von Speicherblöcken (MB1 - MB4) mit jeweils einer Anzahl von Speicherzellen (MC),
einer Anzahl peripherer Schaltungsblöcke (13,14), von denen jeder für einen zugeordneten Speicherblock (MB1 - MB4) vorgesehen ist und wobei jeder der peripheren Schaltungsblöcke (13,14) an seinem Ausgangsende ein Lesesignal von dem zugeordneten Speicherblock ableitet,
einer zweiten Zahl von Ausgangsanschlüssen (I/O₁ bis I/O₂), wobei die zweite Zahl kleiner ist als die erste Zahl, und einer programmierbaren Schaltung (15,16) zum selektiven Herstellen eines Signalweges zwischen der zweiten Zahl von Ausgangsanschlüssen (I/O₁ bis I/O₂) und den Ausgangsenden der zweiten Zahl der peripheren Schaltungsblöcke (13,14),
wodurch die verbleibenden peripheren Schaltungsblöcke (13,14) oder andere Blöcke als die Zahl der peripheren Schaltungsblöcke (13,14) feststehend von jedem der Ausgangsanschlüsse (I/O₁ bis I/O₂) isoliert sind, dadurch **gekennzeichnet**, daß die programmierbare Schaltung (15,16) eine Anzahl von Schalteinheiten (16-1 bis 16-5) der ersten Zahl aufweist,
jede der Schalteinheiten einen gemeinsamen Knoten (N₃) und eine Anzahl von Schaltknoten (N₁,N₂) aufweist, die selektiv mit dem gemeinsamen Knoten (N₃) verbunden werden,
wobei der gemeinsame Knoten (N₃) jeder der Schalteinheiten (16-1 bis 16-5) mit dem Ausgangsende des zugeordneten peripheren Schaltungsblocks (13,14) verbunden ist,
wobei jeder der Ausgangsanschlüsse (I/O₁ bis I/O₂) elektrisch mit den Schaltknoten (N₁,N₂) der unterschiedlichen zwei oder mehr Schalteinheiten (16-1 bis 16-5) verbunden ist.

2. Speicherschaltung nach Anspruch 1, wobei die Speicherblöcke (MB1 - MB4) eine Anzahl von Wortleitungen (WL) gemeinsam aufweisen.

3. Speicherschaltung nach Anspruch 1, wobei jeder der peripheren Schaltungsblöcke (13,14) eine Spaltenauswahlschaltung (13) aufweist, zum Auswählen einer der Spalten des zugeordneten Speicherblocks und eine Pufferschaltung zum Verstärken eines Signals aus der ausgewählten Spalte.

4. Speicherschaltung nach einem der vorstehenden Ansprüche, mit einer Anzahl programmierbarer Steuereinrichtungen (15-1 bis 15-5) zum Steuern der Leitungszustände der Schalteinheiten (16-1 bis 16-5).

## Revendications

1. Circuit de mémoire comprenant :
un premier nombre de blocs de mémoire (MB1 - MB4) dont chacun comporte une pluralité de cellules de mémoire (MC) ;
une pluralité de blocs de circuit périphérique (13, 14) dont chacun est prévu pour être associé à l'un desdits blocs de mémoire (MB1 - MB4), chacun desdits blocs de circuit périphérique (13, 14) dérivant un signal de lecture au niveau de son extrémité de sortie depuis le bloc de mémoire associé ;
un second nombre de bornes de sortie (I/O₁ à I/O₂), ledit second nombre étant inférieur audit premier nombre ; et
un circuit de commutateur programmable (15, 16) pour constituer sélectivement une voie de signal entre ledit second nombre de bornes de sortie (I/O₁ à I/O₂) et des extrémités de sortie dudit second nombre de blocs de circuit périphérique (13, 14) de telle sorte que les blocs de circuit périphérique restants (13, 14) ou les blocs autres que ledit nombre de blocs de circuit périphérique (13, 14) soient isolés de façon fixe de l'une quelconque desdites bornes de sortie (I/O₁ à I/O₂),
caractérisé en ce que :
ledit circuit de commutateur programmable (15, 16) inclut des unités de commutateur (16-1 à 16-5) en un nombre égal audit premier nombre ;
chacune desdites unités de commutateur comportant un noeud commun (N₃) et une pluralité de noeuds de commutateur (N₁, N₂) en vue d'une connexion sélective au noeud commun (N₃) ;
le noeud commun (N₃) de chacune desdites unités de commutateur (16-1 à 16-5) étant connecté à l'extrémité de sortie dudit bloc de circuit périphérique associé (13, 14) ;
chacune desdites bornes de sortie (I/O₁ à I/O₂) étant couplée électriquement aux noeuds de commutateur (N₁, N₂) de deux unités de commutateur optique différentes ou plus (16-1 à 16-5).

2. Circuit de mémoire selon la revendication 1, dans lequel lesdits blocs de mémoire (MB1-MB4) comportent une pluralité de lignes de mot (WL) en commun.

3. Circuit de mémoire selon la revendication 1, dans lequel chacun desdits blocs de circuit périphérique (13, 14) inclut un circuit de sélection de colonne (13) pour sélectionner l'une des colonnes du bloc de mémoire associé et un circuit de tampon (14) pour amplifier un signal provenant de la colonne sélectionnée.

4. Circuit de mémoire selon l'une quelconque des revendications précédentes, comprenant une pluralité de moyens de commande programmables (15-1 à 15-5) pour commander des états conducteurs desdites unités de commutateur (16-1 à 16-5).
